# EUROPÄISCHE PATENTSCHRIFT

(11) **EP 2 056 656 B1**
(45) Veröffentlichungstag und Bekanntmachung des Hinweises auf die Patenterteilung: **23.08.2017**
(21) Anmeldenummer: 08018242.1
(22) Anmeldetag: 17.10.2008
(51) Int. Cl.: H05K 3/04, H05K 3/38, H05K 3/24, H05K 1/03

(54) **Verfahren zur Herstellung einer flexiblen Leiterbahnstruktur**
Method for manufacturing a flexible PCB board structure
Procédé de fabrication d'une structure conductrice flexible

(30) Priorität: 29.10.2007 DE 102007051930
(43) Veröffentlichungstag der Anmeldung: 06.05.2009
(73) Patentinhaber: Leonhard Kurz Stiftung & Co. KG, 90763 Fürth (DE)
(72) Erfinder: Rohm, Michael, 90768 Fürth (DE); Attner, Juri, 90559 Burgthann (DE)
(74) Vertreter: Zinsinger, Norbert

(56) Entgegenhaltungen:
- WO-A1-2006/027947
- WO-A2-2005/039868
- US-A1- 2007 149 001

## Beschreibung

Die Erfindung betrifft ein Verfahren zur Herstellung einer Leiterbahnstruktur auf einer flexiblen Kunststofffolie. Die Erfindung betrifft weiterhin danach gebildete Leiterbahnstrukturen und elektronische Bauelemente oder Schaltungen mit einer derartigen Leiterbahnstruktur.

Bei der Massenproduktion von elektronischen Bauelementen oder Schaltungen ist meist eine Strukturierung, d.h. bereichsweise oder musterförmige Ausgestaltung, der elektrisch leitenden Funktionsschichten der einzelnen Bauelemente sowie gegebenenfalls deren Verbindungsleitungen zur Ausbildung von Schaltungen erforderlich. Dabei werden Leiterbahnstrukturen umfassend elektrisch leitende Anschlussflächen, Elektrodenflächen, Leiterbahnen, Antennenelemente, Spulenelemente usw. aus elektrisch leitendem Material auf einem elektrisch isolierenden Substrat ausgebildet und weitere Funktionsschichten wie Halbleiterschichten, elektrisch isolierende Schichten, Haftvermittlerschichten usw. daran angrenzend ausgebildet, um die Bauelemente und Schaltungen auf dem Substrat aufzubauen. Als elektrisch isolierende Substrate sind dabei zunehmend flexible, d.h. biegsame Substrate, wie zum Beispiel Folien aus Kunststoff oder Folien enthaltend eine Oberfläche aus Kunststoff im Einsatz, die während der Ausbildung der einzelnen Schichten der Bauelemente und Schaltungen kontinuierlich von Rolle zu Rolle transportiert werden können. Flexible Substrate ermöglichen somit in einfacher Weise eine Massenproduktion von dünnen, flexiblen und kostengünstigen Bauelementen und/oder Schaltungen, sofern die einzelnen Schichten, mit denen die Bauelemente und Schaltungen aufgebaut werden, jeweils oder in Summe eine so geringe Schichtdicke aufweisen, dass die Flexibilität des Substrats nicht oder nur unwesentlich beeinträchtigt wird.

Generell sind bereits diverse Verfahren zur Herstellung von Leiterbahnstrukturen auf Kunststoffoberflächen bekannt.

Bei einem bekannten Verfahren wird eine metallische Dünnfilmschicht, beispielsweise durch Aufdampfen oder Sputtern, auf dem elektrisch isolierenden Substrat gebildet und anschließend galvanisch verstärkt. Unter einer Dünnfilmschicht wird hier eine Schicht mit einer Schichtdicke vorn ≤ 2 µm verstanden, vorzugsweise mit einer Schichtdicke von bis zu 0,5 µm, insbesondere mit einer Schichtdicke von bis zu 0,1 µm. Hierbei hat es sich jedoch gezeigt, dass bei der Verwendung flexibler Substrate oder Folien, bei welchen zumindest die zu beschichtende Oberfläche aus Kunststoff gebildet ist, häufig eine unzureichende Galvanisierung der Dünnfilmschicht resultiert.

Dies wird derzeit auf eine zu geringe Haftung und/oder zu geringe Dicke der Dünnfilmschicht zurückgeführt, die zu einer Abschwemmung der Dünnfilmschicht während der Verweildauer dieser im galvanischen Bad führt. Um ein einwandfreies Ergebnis zu erhalten, wurde bisher bei Verwendung von derartigen flexiblen Substraten, bei welchen zumindest die zu beschichtende Oberfläche aus Kunststoff gebildet ist, anstelle einer Dünnfilmschicht ein Verfahren eingesetzt, bei dem auf das Substrat eine Leitpaste enthaltend Metallpartikel musterförmig aufgedruckt, verfestigt und galvanisch verstärkt wird. Die gebildete Leitpastenschicht ist eine Dickfilmschicht, wobei hier unter einer Dickfilmschicht eine Schicht mit einer Schichtdicke von mehr als 2 µm, insbesondere von mehr als 10 µm verstanden wird. Aufgrund des höheren Materialeinsatzes bei Verwendung einer Leitpaste im Vergleich zur Verwendung einer Dünnfilmschicht ist das Leitpasten-Verfahren somit wesentlich kostenintensiver.

Die US 2007/0149001 A1 befasst sich ebenfalls mit der Problematik, dass man beim Aufbringen eines leitfähigen Musters aus Kupfer einen Klebstoff verwenden muss, der entweder gut am Kupfer haftet, nicht aber am Substrat, oder umgekehrt gut am Substrat haftet, dabei aber das Kupfer sich von ihm lösen kann. Zur Lösung dieser Problemstellung gibt die US 2007/0149001 A1 an, dass der Klebstoff in ein Gewebe eingebracht werden kann, insbesondere in einem Klebstoffbad. Dadurch, dass der Klebstoff in das Gewebe eingebracht wird, kann man einen solchen Klebstoff verwenden, der besonders gut an dem leitfähigen Muster haftet, nicht aber unbedingt an dem Material des Gewebes selbst.

Das Dokument offenbart mehrere Ausführungsformen. Bei einer Ausführungsform spielt das Aufbringen einer leitfähigen Folie eine Rolle. Bei einer anderen Ausführungsform kann ein leitfähiges Muster durch einen Ätzprozess aufgebracht werden. Weiter alternativ kann ein Zusatzverfahren eingesetzt werden, um ein solches leitfähiges Muster vorzusehen. Das Zusatzverfahren kann ein Galvanisieren umfassen.

Die WO 2006/027947 A1 befasst sich mit der chemischen Zusammensetzung einer Flüssigkeit, mithilfe der eine Kupferschicht stromlos aufgebracht werden kann. Die Flüssigkeit wird im Wesentlichen vollflächig aufgebracht. Durch Galvanisieren kann eine Kupferschicht weiter aufgebracht werden.

Die Vorbehandlung mit der Flüssigkeit wird in der WO 2006/027947 A1 als vorteilhaft im Vergleich zu herkömmlichen Verfahren angesehen, wozu beispielsweise das Aufbringen einer Kupfersaatschicht durch Sputtern genannt wird.

Ein weiteres Verfahren zur Herstellung von Leiterbahnstrukturen auf elektrisch isolierenden, flexiblen Substraten ist aus WO 2005/039868 A2 bekannt. Hier wird als elektrisch isolierendes Substrat bevorzugt eine flexible, dünne Kunststofffolie eingesetzt. Auf der Kunststofffolie wird eine Kleberschicht bereitgestellt, die mit einer elektrisch leitenden Schicht verbunden wird, welche auf einer Transferfolie bereitgestellt ist. Transferfolien weisen bekanntermaßen eine selbsttragende Trägerfolie und eine nicht selbsttragende Übertragungslage auf, die von der Trägerfolie ablösbar ist. Die Übertragungslage wird aus mindestens einer Schicht gebildet, hier beispielsweise einer metallischen Schicht zur Ausbildung einer Leiterbahnstruktur. Bei diesem bekannten Verfahren handelt es sich um ein trockenes Verfahren, durch das eine Verunreinigung von organischen Halbleiterschichten weitgehend vermieden wird. Die organischen halbleitenden Schichten eines organischen elektronischen Bauelements sind extrem empfindlich gegenüber Verunreinigungen, da diese bereits in geringen Konzentrationen die elektrischen Eigenschaften der organischen Halbleiterschicht verändern können.

Es ist nun Aufgabe der Erfindung, ein weiteres Verfahren zur Herstellung von Leiterbahnstrukturen, danach gebildete Leiterbahnstrukturen und mit diesen ausgebildete elektronische Bauelemente und Schaltungen anzugeben.

Die Aufgabe wird für das Verfahren zur Herstellung einer Leiterbahnstruktur auf einer flexiblen Kunststofffolie gelöst, indem auf die Kunststofffolie oder eine Transferfolie eine durch Bestrahlung vernetzbare Kleberschicht aufgebracht wird und die Kunststofffolie und die Transferfolie mittels der Kleberschicht miteinander verbunden werden, wobei die Transferfolie, die eine Trägerfolie und eine elektrisch leitende Dünnfilmschicht aufweist, mit einer Orientierung der Dünnfilmschicht zur durch Bestrahlung vernetzbaren Kleberschicht auf die Kunststofffolie aufgebracht wird, wobei die durch Bestrahlung vernetzbare Kleberschicht musterförmig ausgebildet und/oder derart musterförmig bestrahlt wird, dass die Kleberschicht nach Bestrahlung musterförmig in vernetzter, ausgehärteter Form vorliegt, und wobei die Trägerfolie von dem die Kunststofffolie, die zumindest bereichsweise ausgehärtete Kleberschicht und die Dünnfilmschicht umfassenden Folienkörper abgezogen wird, wobei in einem ersten musterförmigen Bereich die Dünnfilmschicht auf der Kunststofffolie verbleibt und in einem zweiten musterförmigen Bereich die Dünnfilmschicht auf der Trägerfolie verbleibt und mit der Trägerfolie von der Kunststofffolie abgezogen wird, und wobei die Leiterbahnstruktur gebildet wird, indem die im ersten musterförmigen Bereich auf der Kunststofffolie verbliebene Dünnfilmschicht galvanisch mit mindestens einer Metallschicht verstärkt wird.

Die Aufgabe wird für die Leiterbahnstruktur auf einer flexiblen Kunststofffolie, gelöst, indem diese nach dem erfindungsgemäßen Verfahren hergestellt ist, wobei die Leiterbahnstruktur mittels einer durch Bestrahlung ausgehärteten Kleberschicht mit der Kunststofffolie verbunden ist und aus einer galvanisch mit mindestens einer Metallschicht verstärkten, musterförmigen elektrisch leitfähigen Dünnfilmschicht gebildet ist.

Die Aufgabe wird weiterhin für das elektronische Bauelement oder die elektronische Schaltung mit einer erfindungsgemäßen Leiterbahnstruktur gelöst, wobei das elektronische Bauelement ein Widerstand, ein Kondensator, eine Induktivität, ein Feldeffekttransistor (FET), eine Diode, eine Leuchtdiode (LED), eine Solarzelle, ein OLED-Display oder eine Folienbatterie ist oder dass die elektronische Schaltung mindestens ein derartiges Bauelement umfasst.

Überraschender Weise hat es sich gezeigt, dass bei einer Vorgehensweise gemäß dem erfindungsgemäßen Verfahren eine elektrisch leitende, insbesondere metallische, Dünnfilmschicht durchaus in einem Galvanisierungsprozess einwandfrei mit mindestens einer Metallschicht verstärkt werden kann. Wider Erwarten ist hier kein Abschwemmen der Dünnfilmschicht von der Kunststofffolie zu beobachten, wie es bei der direkten Bildung einer Dünnfilmschicht auf einer solchen auftritt. Dies wird derzeit dadurch erklärt, dass aufgrund der Kleberschicht die Haftung der Dünnfilmschicht an der Kunststofffolie generell, und vor allem während des Galvanisiervorganges, deutlich verbessert ist.

Durch das erfindungsgemäße Verfahren ist es möglich, die Leiterbahnstrukturen eines Bauelements oder einer Schaltung registergenau und mit hoher Auflösung zu strukturieren. So ist es beispielsweise möglich, Abstände zwischen einer Source- und einer Drain-Elektrode eines organischen Feldeffekt-Transistors zu erzielen, die geringer als 50 µm sind. Aufgrund der mindestens einen gaivanisch gebildeten Metallschicht ist die elektrische Leitfähigkeit der erfindungsgemäßen Leiterbahnstruktur deutlich höher als bei einer durch eine Dünnfilmschicht gebildeten Leiterbahnstruktur, so das die elektrischen Eigenschaften der Bauelemente oder Schaltungen, wie zum Beispiel der geringere elektrische Widerstand, die aufgrund folglich geringerer parasitärer Kapazitäten erhöhte Schaltgeschwindigkeit oder die erhöhte Belastbarkeit mit größeren Stromstärken, verbessert werden. Weitere Vorteile des erfindungsgemäßen Verfahrens liegen darin, dass dieses sehr kostengünstig und für den großindustriellen Einsatz geeignet ist. Weiterhin wird eine thermische Belastung elektrischer Funktionsschichten der Bauelemente oder Schaltungen während des Herstellungsprozesses vermieden.

Vorteilhafte Ausgestaltungen des erfindungsgemäßen Verfahrens, der erfindungsgemäßen Leiterbahnstruktur und der erfindungsgemäßen elektronischen Bauelemente oder Schaltungen sind in den Unteransprüchen bezeichnet.

Generell ist es für das erfindungsgemäße Verfahren möglich, die Kleberschicht entweder unmittelbar auf die Kunststofffolie aufzutragen oder aber unmittelbar auf die Seite der Transferfolie aufzutragen, auf der sich die Dünnfilmschicht befindet. Es ist lediglich darauf zu achten, dass nach dem Zusammenführen der Kunststofffolie und der Transferfolie die Kleberschicht zwischen der Kunststofffolie und der Dünnfilmschicht angeordnet ist. Dies gilt auch für die nachfolgend beschriebenen bevorzugten Ausführungsformen des erfindungsgemäßen Verfahrens.

Als elektronische Bauelemente werden insbesondere organische elektronische Bauelemente eingesetzt, die zumindest eine Schicht aus einem organischen Halbleitermaterial umfassen, insbesondere ein OFET, eine OLED oder ein Triac.

Organische Halbleitermaterialien, organische elektrisch leitfähige Materialien und organische elektrisch isolierende Materialien werden hierbei von organischen, metall-organischen und/oder anorganischen Substanzen, insbesondere Polymeren, gebildet, die die jeweiligen elektrischen Eigenschaften besitzen. Als organisches Halbleiter-Material kann beispielsweise Polythiophen Verwendung finden.

Vorzugsweise ist das elektronische Bauelement oder die Schaltung mechanisch flexibel ausgebildet. Als flexibel wird ein Bauelement oder eine Schaltung bezeichnet, wenn die Kunststofffolie inklusive aller erforderlichen elektrischen Funktionsschichten und gegebenenfalls weiterer Schichten, wie Schutzschichten, usw., so biegsam ist, dass ein Biegeradius von wenigen Zentimetern, insbesondere von < 10 cm nachgeformt werden kann, ohne dass es zu einer Beschädigung der Kunststofffolie oder darauf aufgebrachter Schichten des Bauelements oder der Schaltung kommt. Unter einer Beschädigung wird dabei sowohl eine sichtbare Veränderung, wie ein Ablösen oder Abheben, ein Bruch, eine Verfärbung oder dergleichen verstanden, wie auch eine unsichtbare, jedoch messbare Veränderung, wie eine Verschlechterung elektrischer Eigenschaften (z.B. des elektrischen Widerstands, der Schaltgeschwindigkeit, usw.).

Unter einer Kunststofffolie wird im Sinne der Erfindung nicht nur eine Kunststofffolie oder eine Kunststoffschicht aus einem einzigen Kunststoffmaterial verstanden, sondern auch Laminate aus gleichen oder unterschiedlichen Kunststofffolien oder Kunststoffschichten sowie Laminate umfassend mindestens eine Kunststofffolie oder Kunststoffschicht und weiterhin mindestens eine Lage aus Papier und/oder Metall und/oder dielektrischem anorganischem oder organischem Material, sofern die Oberfläche, auf die die durch Bestrahlung vernetzende Kleberschicht aufgebracht wird, aus Kunststoff, worunter hier auch ein Lack fällt, gebildet ist. Die Kunststofffolie kann beispielsweise Lackschichten, elektrisch isolierende Schichten, halbleitende Schichten oder elektrisch leitende Schichten umfassen. So ist es möglich, dass die Kunststofffolie bereits Schichten aus organischen elektrisch leitfähigen Polymeren, wie Polyanilin und Polypyrrol, halbleitende Schichten, beispielsweise aus Polythiophen, und elektrisch isolierende Schichten, beispielsweise aus Polyvinylphenol, aufweist. Hierbei ist es auch möglich, dass diese Schichten bereits in strukturierter Form, also lediglich bereichsweise, in oder auf der Kunststofffolie vorliegen. Die Oberfläche der Kunststofffolie, auf welcher die Leiterbahnstruktur gebildet wird, ist vorzugsweise aus einem elektrisch isolierenden Kunststoff ausgebildet. Dies ist insbesondere dann erwünscht, wenn die durch Bestrahlung vernetzbare Kleberschicht elektrisch leitend ausgebildet ist und/oder die Kleberschicht musterförmig ausgebildet wird. Bei Verwendung einer elektrisch isolierenden Kleberschicht, die vollflächig auf die Kunststofffolie aufgebracht wird, kann die Oberfläche der Kunststofffolie, auf welcher die Leiterbahnstruktur gebildet wird, auch elektrisch leitfähig ausgebildet sein. Auch eine Kombination einer Oberfläche der Kunststofffolie aus einem halbleitenden Material mit einer musterförmigen Kleberschicht ist möglich, sofern die freiliegenden Bereiche der Oberfläche im Galvanikbad nicht beschichtbar sind.

Vorzugsweise weist die Kunststofffolie eine Dicke im Bereich von 6 bis 200 µm, insbesondere im Bereich von 12 bis 150 µm auf. Eine Kunststofffolie aus PET, PC, BOPP, PEN, PVC, ABS, oder Polyimid hat sich bewährt. Weiterhin hat es sich bewährt, wenn die Kunststofffolie thermisch stabilisiert, d.h. vor ihrer Verwendung getempert wurde.

Zur Vernetzung und Aushärtung der durch Bestrahlung vernetzbaren Kleberschicht wird vorzugsweise ultraviolette Strahlung oder Infrarotstrahlung eingesetzt. Dadurch können bestrahlte Bereiche der Kleberschicht besonders schnell und unkompliziert vernetzt und ausgehärtet werden. Strahler zur Erzeugung solcher Strahlungsarten sind hinreichend erprobt und kommerziell in vielen verschiedenen Bauformen verfügbar.

Die durch Bestrahlung ausgehärtete Kleberschicht weist insbesondere eine Schichtdicke von ≤ 50 µm, insbesondere von ≤ 2 µm auf. Vorzugsweise liegt die Schichtdicke im Bereich von 0,5 bis 2 µm. Eine Kleberschicht in einer derart geringen Schichtdicke lässt sich optimal in den Aufbau von aus Schichten aufgebauten elektronischen Bauelementen oder Schaltungen integrieren. Weiterhin ist eine derart dünne Kleberschicht üblicherweise flexibel, so dass die Biegsamkeit der Kunststofffolie, auf der die Bauelemente bzw. Schaltungen ausgebildet werden, nicht oder nur unwesentlich beeinträchtigt wird.

Für das Verfahren ist es bevorzugt, wenn die durch Bestrahlung vernetzbare Kleberschicht mittels eines Druckverfahrens musterförmig ausgebildet wird, wenn die musterförmige Kleberschicht durch Bestrahlung ausgehärtet wird, und wenn die Trägerfolie von dem die Kunststofffolie, die ausgehärtete musterförmige Kleberschicht und die Dünnfilmschicht umfassenden Folienkörper abgezogen wird, wobei in dem ersten musterförmigen Bereich, in welchem die ausgehärtete Kleberschicht vorliegt, die Dünnfilmschicht auf der Kunststofffolie verbleibt und in dem zweiten musterförmigen Bereich, in welchem keine Kleberschicht vorliegt, die Dünnfilmschicht auf der Trägerfolie verbleibt und mit der Trägerfolie von der Kunststofffolie abgezogen wird. Durch ein derartiges Vorgehen lassen sich musterförmige Leiterbahnstrukturen in sehr hoher Auflösung und ausgezeichneter elektrischer Leitfähigkeit auf der Kunststofffolie erzeugen.

Sofern zwischen dem Zeitpunkt der Bestrahlung der musterförmigen Kleberschicht und dem Eintritt der Vernetzung und Aushärtung der Kleberschicht eine ausreichend große Zeitspanne vorhanden ist, so kann hier aber auch ein Zusammenfügen der Transferfolie mit der Kunststofffolie unmittelbar nach Bestrahlung der musterförmigen Kleberschicht erfolgen.

Es ist vorteilhaft, zur Bildung der musterförmigen Kleberschicht auf der Kunststofffolie kostengünstige und großindustriell anwendbare Drucktechniken, wie Tiefdruck, Offset-Druck, Flexo-Druck oder Siebdruck zu verwenden.

Weiterhin hat es sich bewährt, wenn die durch Bestrahlung vernetzbare Kleberschicht vollflächig auf die Kunststofffolie oder die Transferfolie aufgebracht wird und nach dem Verkleben der Transferfolie mit der Kunststofffolie musterförmig bestrahlt wird, wodurch die Kleberschicht in dem ersten musterförmigen Bereich aushärtet, und wenn die Trägerfolie von dem die Kunststofffolie, die bereichsweise ausgehärtet vorliegende Kleberschicht und die Dünnfilmschicht umfassenden Folienkörper abgezogen wird, so dass die Dünnfilmschicht in dem musterförmigen ersten Bereich, in dem die ausgehärtete Kleberschicht vorliegt, auf der Kunststofffolie verbleibt und in dem zweiten Bereich, in welchem nach wie vor die durch Bestrahlung vernetzbare Kleberschicht vorliegt, mit der Trägerfolie von der Kunststofffolie abgezogen wird. Durch ein derartiges Vorgehen lassen sich musterförmige Leiterbahnstrukturen in sehr hoher Auflösung und ausgezeichneter elektrischer Leitfähigkeit auf der Kunststofffolie erzeugen. Weiter ergeben sich hier Kostenvorteile, da beispielsweise der Einsatz hochwertiger Tiefdruck-Rasterwalzen nicht notwendig ist, der zum oben beschriebenen musterförmigen Drucken einer Kleberschicht notwendig ist.

Sofern zwischen dem Zeitpunkt der musterförmigen Bestrahlung der Kleberschicht und dem Eintritt der Vernetzung und Aushärtung der musterförmig bestrahlten Bereiche der Kleberschicht eine ausreichend große Zeitspanne vorhanden ist, so kann hier aber auch ein Zusammenfügen der Transferfolie mit der Kunststofffolie unmittelbar nach der musterförmigen Bestrahlung der Kleberschicht erfolgen.

Es hat sich als vorteilhaft erwiesen, wenn die Dünnfilmschicht semi-transparent ausgebildet wird, wenn die Trägerfolie für die Bestrahlung durchlässig ausgebildet wird und die Kleberschicht von Seiten der Transferfolie durch die Transferfolie hindurch bestrahlt wird. Es hat sich aber genauso bewährt, wenn die Kunststofffolie für die Bestrahlung durchlässig ausgebildet wird und die Kleberschicht von Seiten der Kunststofffolie durch die Kunststofffolie hindurch bestrahlt wird. Dabei ist es selbstverständlich, dass in beiden Fällen zumindest eine Durchlässigkeit für die Bestrahlungsart vorhanden sein muss, die zur Vernetzung der Kleberschicht eingesetzt wird. Eine für das menschliche Auge wahrnehmbare Durchsichtigkeit ist gegebenenfalls, aber nicht zwingend vorhanden.

Bei dieser Ausführungsform ist es insbesondere von Vorteil, wenn die durch Bestrahlung vernetzbare Kleberschicht eine geringere Adhäsionskraft gegenüber der Dünnfilmschicht besitzt, als die Adhäsionskraft zwischen der Dünnfilmschicht und den restlichen Schichten der Transferfolie, wie der Trägerfolie oder einer Ablöseschicht, die gegebenenfalls zwischen der Dünnfilmschicht und der Trägerfolie angeordnet ist, beträgt. Dadurch lässt sich ein problemloses Abziehen der Trägerfolie inklusive der dem musterförmigen zweiten Bereich zugeordneten Bereiche der Dünnfilmschicht von der Kunststofffolie erreichen.

In einer weiteren bevorzugten Ausführungsform ist vorgesehen, dass die durch Bestrahlung vernetzbare Kleberschicht vollflächig auf die Kunststofffolie oder die Transferfolie aufgebracht wird, dass vor dem Verkleben der Transferfolie mit der Kunststofffolie die Kleberschicht musterförmig bestrahlt wird, so dass die Kleberschicht musterförmig aushärtet, dass die Transferfolie und die Kunststofffolie mittels der bereichsweise ausgehärtet vorliegenden Kleberschicht miteinander verklebt werden, dass die Kleberschicht nun erneut bestrahlt und in weiteren oder allen Bereichen ausgehärtet wird, dass die Trägerfolie von dem die Kunststofffolie, die zumindest bereichsweise ausgehärtete Kleberschicht und die Dünnfilmschicht umfassenden Folienkörper abgezogen wird, so dass die Dünnfilmschicht in dem ersten Bereich, in dem die Kleberschicht erst nach Zusammenführen der Transferfolie und der Kunststofffolie ausgehärtet wurde, auf der Kunststofffolie verbleibt und in dem zweiten Bereich, in dem die Kleberschicht bereits vor dem Zusammenführen der Transferfolie mit der Kunststofffolie ausgehärtet war und gegebenenfalls in noch vorliegenden Bereichen mit durch Bestrahlung vernetzbarer Kleberschicht, mit der Trägerfolie von der Kunststofffolie abgezogen wird.

Der Einsatz des erfindungsgemäßen Verfahrens im Rahmen eines großindustriellen Rolle-zu-Rolle-Prozesses wird durch die Verwendung eines Trommel-Belichters oder eines Masken-Belichters mit einem umlaufenden Maskenband für die musterförmige Bestrahlung der Kleberschicht, insbesondere mit ultravioletter Strahlung, ermöglicht.

Weiter hat es sich als vorteilhaft gezeigt, die Dünnfilmschicht beim Zusammenführen mit der Kunststofffolie zu komprimieren, so dass sich deren elektrische Leitfähigkeit durch die Verpressung erhöht.
Von besonderer Bedeutung für das erfindungsgemäße Verfahren ist die Verwendung einer geeigneten Transferfolie, die eine schnelle und präzise Ablösung der Dünnfilmschicht von der Trägerfolie ermöglicht. Hierbei hat es sich insbesondere als zweckmäßig herausgestellt, zwischen der Trägerfolie und der Dünnfilmschicht der Transferfolie eine Ablöseschicht, beispielsweise aus Wachs, Silikon oder PTFE, vorzusehen, die eine definierte Einstellung des Ablöseverhalten weitgehend unabhängig von der verwendeten Trägerfolie ermöglicht.

Es ist bevorzugt, wenn die Dünnfilmschicht durch Sputtern oder Aufdampfen oder durch Abscheiden aus einer Flüssigkeit, wie einer Paste, Dispersion oder Lösung, auf der Trägerfolie oder der gegebenenfalls vorhandenen Ablöseschicht gebildet wird. Die Dünnfilmschicht wird auf der Trägerfolie oder Ablöseschicht vorzugsweise in einer Schichtdicke von ≤ 2 µm, insbesondere im Bereich von ≤ 50 nm oder im Bereich vorn ≤ 10 nm gebildet.

Die elektrisch leitende Dünnfilmschicht wird/ist insbesondere aus Metall oder einer Metall-Legierung gebildet, insbesondere aus Silber, Gold, Kupfer, Aluminium oder Zinn oder die elektrisch leitende Dünnfilmschicht wird/ist aus einem organischen Material gebildet, insbesondere aus PEDOT.

Dabei kann die Dünnfilmschicht aus einer Einzelschicht oder aus mindestens zwei Einzelschichten, die aus unterschiedlichen Materialien gebildet sind, gebildet sein.

Die mindestens eine auf der Dünnfilmschicht galvanisch abgeschiedene Metallschicht wird/ist vorzugsweise aus Kupfer, Chrom, Gold, Silber, Nickel, Zink, gebildet.

Die Leiterbahnstruktur, gebildet durch die Dünnfilmschicht und die mindestens eine Metallschicht zusammen, ist vorzugsweise in einer Schichtdicke im Bereich von 1 bis 50 µm ausgebildet. Derartige Leiterbahnstrukturen weisen eine hohe elektrische Leitfähigkeit auf und gewährleisten einen störungsfreien Betrieb von damit aufgebauten Bauelementen oder Schaltungen.

Es hat sich bewährt, wenn mindestens zwei Metallschichten aus unterschiedlichen Materialien galvanisch auf der musterförmigen Dünnfilmschicht ausgebildet werden. Dabei kann eine erste abgeschiedene Metallschicht aus einem weniger edlen Metall, wie beispielsweise Kupfer, gebildet sein, und eine zweite abgeschiedene Metallschicht aus einem edleren Metall, beispielsweise aus Gold, gebildet sein. Die Goldschicht deckt die erste Metallschicht und die Dünnfilmschicht auf ihrer, der Kunststofffolie abgewandten Seite zuverlässig ab und schützt die Leiterbahnstruktur vor oxidativen Einflüssen, wie Sauerstoff aus der Luft, Luftfeuchtigkeit, usw..

Dabei hat es sich bewährt, wenn die mindestens eine Metallschicht mittels elektrolytischer Galvanisierung, bei der im Galvanikbad elektrischer Strom fließt, oder chemischer Galvanisierung, die stromlos erfolgt, gebildet wird.

Die Dünnfilmschicht wird hierbei durch vorzugsweise stabförmige, in einer Kreisbewegung geführte Kontaktelektroden mit einer Stromquelle kontaktiert, so dass die Dünnfilmschicht eine Elektrode des in dem Galvanikbad anliegenden Stromflusses bildet und sich das Beschichtungsmetall auf der Dünnfilmschicht abscheidet.

Ein geeignetes Bad, um beispielsweise Kupfer galvanisch abzuscheiden, weist folgende Zusammensetzung (in Gewichtsteilen) auf:

| | |
|---|---|
| 1000 Teile | H₂O dest. |
| 50 Teile | CuSO₄ |
| ....10 Teile | H₂SO₄ (98%ig) |
| 5 Teile | L-Ascorbinsäure |

Um aus einem derartigen Bad eine Kupferschicht von beispielsweise 12 µm Schichtdicke galvanische abzuscheiden, werden vorzugsweise folgende Parameter gewählt:

| | |
|---|---|
| Abscheidespannung | 12 V |
| Stromdichte | ca. 12 Aldm² |
| Abscheidedauer | ca. 1,5 - 2 min |
| Bad-Temperatur | 50 °C |

Die Dicke der Metallschicht wird umso größer, je höher die Stromdichte, die Abscheidespannung und/oder die Abscheidedauer ist.

Nachfolgend wird die Erfindung anhand von mehreren Ausführungsbeispielen unter Zuhilfenahme der beiliegenden Zeichnungen 1 bis 4e beispielhaft erläutert.

So zeigt:
- Fig. 1: eine funktionelle Darstellung eines Verfahrensablaufs gemäß eines ersten Ausführungsbeispiels;
- Fig. 2: eine funktionelle Darstellung eines Verfahrensablaufs gemäß eines weiteren Ausführungsbeispiels;
- Fig. 3a bis Fig. 3d: Querschnitte durch Folienverbunde gemäß dem Verfahrensablauf nach Fig. 1; und
- Fig. 4a bis Fig. 4e: die Herstellung eines elektronischen Bauelements im Querschnitt.

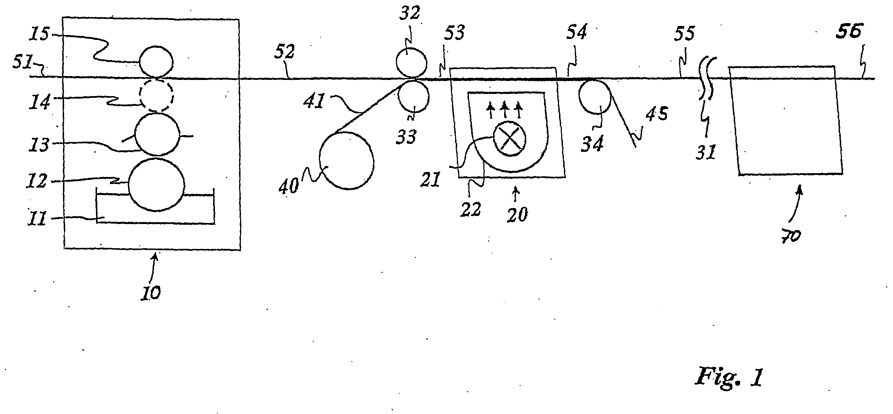

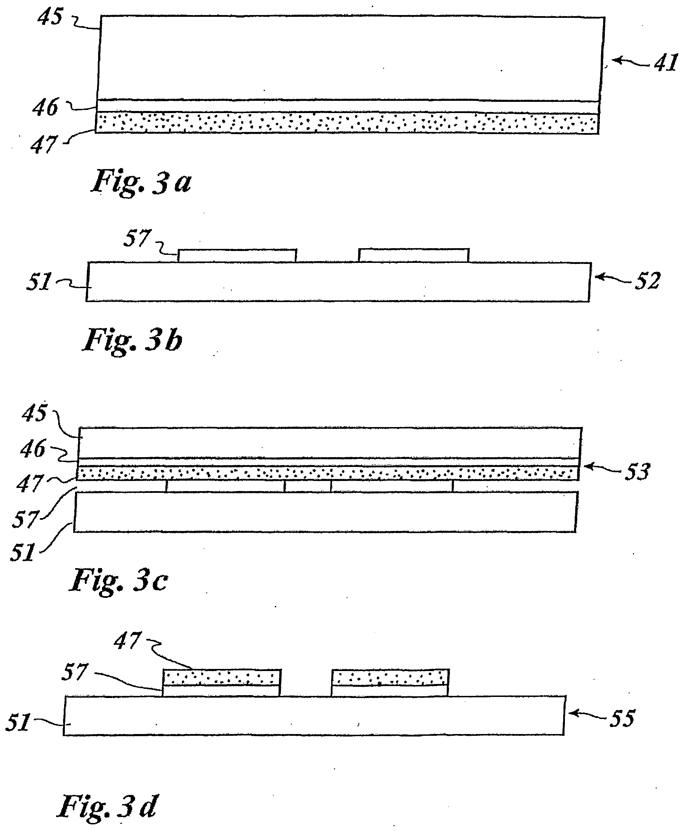

Fig. 1 skizziert einen Ausschnitt aus einem Rolle-zu-Rolle-Fertigungsprozess, in welchem auf einer Kunststofffolie 51 zumindest ein elektrisches Bauelement ausgebildet wird. Fig. 1 zeigt eine Druckstation 10, eine Belichtungsstation 20, drei Walzen 32, 33 und 34, sowie eine Galvanisierstation 70. Eine Kunststofffolie 51 aus PET in einer Dicke im Bereich von 10 bis 150 µm wird der Druckstation 10 zugeführt und mit einer musterförmigen, durch Bestrahlung vernetzbaren Kleberschicht 57 versehen (siehe Fig. 3b). Es ergibt sich die in Fig. 3b im Querschnitt dargestellte, bereichsweise mit Kleber bedruckte Kunststofffolie 52.

Die von der Druckstation 10 mit Kleber bedruckte Kunststofffolie 52 wird dem Walzenpaar 32 und 33 zugeführt, welche die mit Kleber bedruckte Kunststofffolie 52 mit einer, von einer Rolle 40 abgerollten Transferfolie 41 zusammenführt. Die Transferfolie 41 weist eine Trägerfolie 45, eine optionale Ablöseschicht 46 und eine von der Trägerfolie 45 ablösbare, elektrisch leitende Dünnfilmschicht 47 auf (siehe Querschnitt der Transferfolie 41 in Figur 3a), wobei die Dünnfilmschicht 47 beim Zusammenführen der Transferfolie 41 und der mit Kleber bedruckten Kunststofffolie 52 zur Kleberschicht 57 zeigt (Anordnung siehe Figuren 3a und 3b). Es ergibt sich ein erster Folienverbund 53 (siehe Querschnitt des Folienverbunds 53 in Figur 3c) bestehend aus der Transferfolie 41 und der mit Kleber bedruckten Kunststofffolie 52. Der erste Folienverbund 53 wird anschließend der Belichtungsstation 20 zugeführt und die musterförmige Kleberschicht 57 belichtet. Dabei erfolgt eine permanente Fixierung von Bereichen der Dünnfilmschicht 47, die mit der musterförmigen Kleberschicht 57 in Kontakt sind, an der Kunststofffolie 51. Ein zweiter Folienverbund 54 umfassend den ersten Folienverbund 53 mit der ausgehärteten Kleberschicht, wird der Walze 34 zugeführt, wo die Trägerfolie 45 inklusive der nicht mit Kleber an der Kunststofffolie 51 fixierten Bereichen der Dünnfilmschicht 47 als Transferfolienabfall 42 vom zweiten Folienverbund 54 abgezogen wird. Es verbleiben Bereiche der Dünnfilmschicht 47 auf der Kleberschicht 57 fixiert.

Durch die Aushärtung der musterförmigen Kleberschicht 57 wird die Dünnfilmschicht 47 also genau an den Stellen, an denen die Kleberschicht 57 vorgesehen ist, mit der Kunststofffolie 51 dauerhaft verklebt. Wird im folgenden die Trägerfolie 45 abgezogen, so haftet die Dünnfilmschicht 47 in den Bereichen, in denen die Kleberschicht 57 gedruckt ist, an der Kunststofffolie 51 und wird an diesen Stellen aus der Transferfolie 41 herausgetrennt. An den übrigen Stellen überwiegt die Haftung zwischen der Dünnfilmschicht 47 und der Trägerfolie 45, oder gegebenenfalls der Ablöseschicht 46, so dass hier die Dünnfilmschicht 47 auf der Trägerfolie 45 verbleibt. Es liegt nun ein dritter Folienverbund 55 (siehe Querschnitt des Folienverbunds 53 in Figur 3d) vor, der sich aus der Kunststofffolie 51, der ausgehärteten musterförmigen Kleberschicht 57 und der entsprechend deckungsgleich zur musterförmigen Kleberschicht 57 ausgeformten musterförmigen Dünnfilmschicht 47 zusammensetzt, welche mittels der ausgehärteten Kleberschicht 57 an der Kunststofffolie 51 befestigt ist.

Der dritte Folienverbund 55 wird im Bereich 31 auf einer Rolle zwischengespeichert und in Folge der Galvanisierstation 70 zugeführt, in welcher eine galvanische Beschichtung der musterförmigen Dünnfilmschicht 47 erfolgt. Alternativ wird der dritte Folienverbund 55 unmittelbar, d.h. "inline", der Galvanisierstation 70 zugeführt, wobei allerdings eine Anpassung des Druck- und Belichtungsverfahrens an das üblicherweise deutlich langsamere Galvanisierverfahren erfolgen muss, beispielsweise durch Verwendung eines entsprechend lang dimensionierten Galvanikbads und/oder mindestens eine Umlenkeinrichtung für den dritten Folienverbund 55 im Galvanikbad, um eine ausreichend lange Verweildauer im Galvanikbad sicherzustellen.

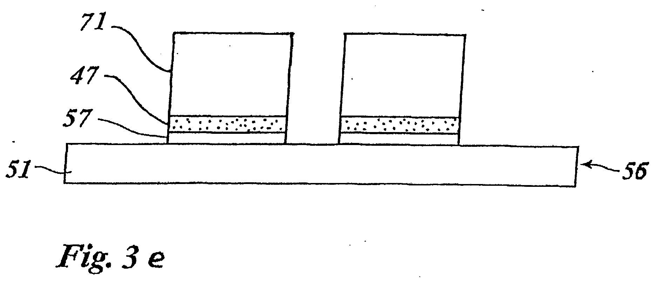

Figur 3e zeigt im Querschnitt den resultierenden vierten Folienverbund 56 nach Verlassen der Galvanisierstation 70, mit der Kunststofffolie 51, der ausgehärteten musterförmigen Kleberschicht 57, der musterförmigen Dünnfilmschicht 47 sowie einer entsprechend der Form der Dünnfilmschicht 47 auf dieser galvanisch abgeschiedenen Metallschicht 71.

Die Druckstation 10 gemäß Figur 1 weist eine Wanne mit einem, durch Bestrahlung mit UV-Licht vernetzbaren Kleber 11 auf. Mittels mehrerer Übertragungswalzen 12 und 13 wird der Kleber 11 auf einen Druckzylinder 14 aufgebracht. Der Druckzylinder 14 bedruckt nun die zwischen dem Druckzylinder 14 und einer Gegendruckwalze 15 hindurch laufende Kunststofffolie 51 bereichsweise mit dem Kleber 11, wobei die musterförmigen Kleber schicht 57 gebildet wird. Bei der Druckstation 10 handelt es sich bevorzugt um eine Offset-Druck-Druckstation oder eine Flexodruck-Druckstation. Es ist jedoch auch möglich, dass es sich bei der Druckstation 10 um eine Tiefdruck- oder Siebdruck-Druckstation handelt.

Bevorzugt wird der Kleber 11 mit einem Auftraggewicht von 1 g/m² - 5 g/m² auf die Kunststofffolie 51 aufgedruckt. Zur Verwendung in einem erfindungsgemäßen Verfahren geeignete, durch Bestrahlung mit UV-Licht vernetzbare Kleber 11 werden beispielsweise unter folgenden Bezeichnungen angeboten:
Foilbond UVH 0002 der Firma AKZO NOBEL INKS und
UVAFLEX UV Adhesive VL000ZA der Firma Zeller + Gmelin GmbH.

Je nach Art des verwendeten Klebers 11 und/oder Art der Verfahrensführung ist es hierbei gegebenenfalls erforderlich, dass die mit Kleber 11 bedruckte Kunststofffolie 52 vor einer weiteren Behandlung einen Trockenkanal durchläuft, in dem die gebildete Kleberschicht 57, beispielsweise bei einer Temperatur im Bereich von 100 bis 120 °C, getrocknet wird.

Die Ablöseschicht 46 der Transferfolie besteht bevorzugt aus Wachs, Silikon oder PTFE. Auf die Ablöseschicht 46 kann auch verzichtet werden, wenn die Materialien der Trägerfolie 45 und der Dünnfilmschicht 47 derart gewählt sind, dass die Adhäsionskräfte zwischen diesen ein sicheres und schnelles bereichsweises Ablösen der Dünnfilmschicht 47 von der Trägerfolie 45 nicht behindern. Vorzugsweise wird die Ablöseschicht 46 in einer Schichtdicke im Bereich von 0,01 bis 0,2 µm auf die Trägerfolie 45 aufgebracht.
Die Ablöseschicht 46 wird beispielsweise nach folgender Rezeptur hergestellt:

| | |
|---|---|
| Toluol | 99,5 Teile |
| Esterwachs (Tropfpunkt 90 °C) | 0,5 Teile |

Die Dünnfilmschicht 47 ist vorzugsweise durch eine dünne metallische Schicht gebildet, welche auf die Trägerfolie 45 und gegebenenfalls die Ablöseschicht 46, insbesondere durch Aufdampfen oder Sputtern, aufgebracht ist. Die Schichtdicke der Dünnfilmschicht 47 liegt insbesondere im Bereich von 5 nm bis 500 nm, um eine hochauflösende Strukturierbarkeit der Dünnfilmschicht 47 mittels des erfindungsgemäßen Verfahrens sicherzustellen.

Besonders gute Ergebnisse lassen sich erzielen, wenn die Dünnfilmschicht 47 elektrisch leitfähige Nano-Partikel aufweist. Eine solche Dünnfilmschicht wird insbesondere in einer Schichtdicke im Bereich von 50 nm bis 1 µm gebildet und setzt sich vorzugsweise aus leitfähigen Nano-Partikeln und Bindemittel zusammen. Die leitfähigen Nano-Partikel werden vorzugsweise in Form einer Dispersion auf die Ablöseschicht 46 aufgebracht, welche anschließend getrocknet wird.

Die Gesamtschichtdicke der Dünnfilmschicht 47 und der Metallschicht 71 zusammen wird hierbei wesentlich durch die im Rahmen des elektronischen Bauelements geforderten elektrischen Eigenschaften, beispielsweise den geforderten spezifischen Widerstand, bestimmt.

Der Anpressdruck, mittels dem die Transferfolie 41 auf die mit Kleber beschichtete Kunststofffolie 52 mittels der Walzen 32, 33 aufgebracht wird, ist so zu wählen, dass die Flächenausdehnung der musterförmigen Kleberschicht 47 auf der Kunststofffolie 51 hierdurch nicht oder nicht wesentlich beeinflusst wird.

Die Belichtungsstation 20 nach Fig. 1 weist eine UV-Lampe 21 sowie einen Reflektor 22 auf, der die von der UV-Lampe 21 abgestrahlte UV-Strahlung auf den ersten Folienverbund 53 bündelt. Die Leistung der UV-Lampe 21 wird hierbei so gewählt, dass die Kleberschicht 57 beim Durchlaufen der Belichtungsstation 20 mit einer ausreichend hohen Energiemenge bestrahlt wird, so dass eine sichere Aushärtung der Kleberschicht 57 gewährleistet ist. Wie in Fig. 1 gezeigt, wird der erste Folienverbund 53 hierbei von Seiten der Transferfolie 41 durch diese hindurch bestrahlt. Dies ist möglich, wenn die Dünnfilmschicht 47 und die Trägerfolie 45, sowie falls vorhanden die Ablöseschicht 46, aus einem für die UV-Strahlung der UV-Lampe transparenten Material bestehen. Ist die Transferfolie 41 für die UV-Strahlung undurchlässig, so ist es möglich, den ersten Folienverbund 53 von Seiten der Kunststofffolie 51 mit UV-Strahlung zu beaufschlagen, wobei dann die Kunststofffolie 51 für die UV-Strahlung der UV-Lampe transparent auszugestalten ist. Auch eine beidseitige Bestrahlung der Kleberschicht 57 ist bei entsprechend ausgestalteter Kunststofffolie 51 und Transferfolie 41 möglich, um die zur Aushärtung des Klebers 11 erforderliche Belichtungszeit bei Bedarf noch zu verkürzen.

Der vierte Folienverbund 56, der die Galvanisierstation 70 verlässt, wird in Folge unmittelbar oder nach einer Zwischenlagerung auf einer weiteren Rolle mindestens einer weiteren Station zugeführt, um das Bauelement zu komplettieren. In mindestens einer, in Figur 1 nicht mehr gezeigten weiteren Station werden die weiterhin erforderlichen elektrischen Funktionsschichten, vollflächig oder musterförmig, ausgebildet, wobei beispielsweise eine oder mehrere Funktionsschichten in Form elektrisch isolierender Schichten, halbleitender Schichten, Haftvermittlerschichten, Schutzschichten, usw. gebildet werden.

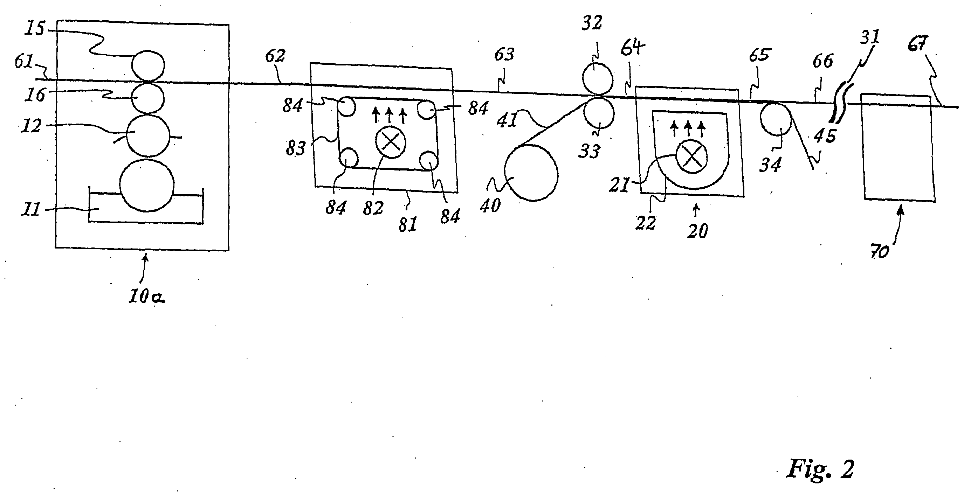

Alternativ zu dem Verfahren gemäß Fig. 1 kann anstelle der verwendeten Belichtungsstation 20 eine Belichtungsstation 81 (siehe Fig. 2) in Form eines Masken-Belichters eingesetzt werden, wobei der Kleberauftrag auf die Kunststofffolie 51, alternativ auf die Transferfolie 41, entweder musterförmig oder vollflächig (siehe Druckstation 10a gemäß Fig. 2) erfolgen kann.

Anhand von Fig. 2 wird nun ein weiteres Ausführungsbeispiel der Erfindung erläutert. Fig. 2 zeigt eine Druckstation 10a, eine erste Belichtungsstation 81, eine Transferfolien-Rolle 40, die Walzen 32, 33 und 34, eine weitere Belichtungsstation 20 und die Galvanisierstation 70.

Die Druckstation 10a gemäß Fig. 2 ist wie die Druckstation 10 nach Fig. 1 aufgebaut, mit dem Unterschied, dass der Druckzylinder 14 durch einen Druckzylinder 16 ersetzt ist, der den Kleber 11 vollflächig auf eine Seite einer zugeführten Kunststofffolie 61 aufbringt. Hierbei ist es auch möglich, dass die Kleberschicht auf die Kunststofffolie 61 nicht durch ein Druckverfahren, sondern durch ein anderes Beschichtungsverfahren, beispielsweise Streichen, Giessen oder Sprühen, aufgebracht wird. Weiter ist es hier auch möglich, dass der Aufdruck der Kleberschicht auf die Kunststofffolie 61 ebenfalls musterförmig erfolgt (wie in Fig. 1 gezeigt) und damit das hier beschriebene Verfahren mit dem Verfahren nach Fig. 1 kombiniert ist.

Die Kunststofffolie 61 und die darauf aufgebrachte Kleberschicht sind wie die Kunststofffolie 51 und die Kleberschicht 57 nach Fig. 3b ausgestaltet, mit dem Unterschied, dass hier die Kleberschicht 57 bevorzugt vollflächig auf die Kunststofffolie 61 aufgebracht wird. Vorzugsweise wird hierbei ein prepolymere UV-vernetzbarer Kleber verwendet. Die mit dem Kleber 11 bedruckte Kunststofffolie 62 wird der ersten Belichtungsstation 81 zugeführt.

Bei der Belichtungsstation 81 handelt es sich um einen Masken-Belichter, der eine Belichtung von Rolle zu Rolle mittels eines mit der Laufgeschwindigkeit der mit Kleber bedruckten Kunststofffolie 62 synchronisierten Maskenbandes ermöglicht. Der Masken-Belichter weist so mehrere Umlenkrollen 84, ein Maskenband 83 und eine UV-Lampe 82 auf. Das Maskenband 83 weist UVtransparente und opake oder reflektierende Bereiche auf. Das Maskenband 83 bildet so eine Endlosmaske, die die mit Kleber bedruckte Kunststofffolie 62 gegenüber der UV-Lampe 82 abdeckt und eine kontinuierliche, musterförmige Bestrahlung der Kleberschicht mit UV-Licht ermöglicht. Die Geschwindigkeit des Maskenbandes 83 wird, wie bereits oben erläutert, mit der Geschwindigkeit der mit Kleber beschichteten Kunststofffolie 62 synchronisiert, wobei zusätzliche optische Markierungen auf der mit Kleber beschichteten Kunststofffolie 62 eine passergenaue, d.h. lagerichtige Belichtung ermöglichen. Die Leistung der UV-Lampe 82 ist hierbei so gewählt, dass eine für die Aushärtung der Kleberschicht ausreichende UV-Energiemenge beim Durchlauf der mit Kleber bedruckten Kunststofffolie 62 durch den Masken-Belichter zugeführt wird. Vorzugsweise wird die vom Masken-Belichter kollimiertes UV-Licht ausgesandt.

Anstelle eines mit einem Maskenband arbeitenden Masken-Belichters ist es auch möglich, einen Trommel-Belichter zu verwenden, der über eine Maske in Form einer Trommel verfügt.

Durch die musterförmige Bestrahlung der Kleberschicht mit UV-Licht härtet die Kleberschicht musterförmig aus, so dass ein Verbund 63 mit musterförmigen ausgehärteten sowie nicht ausgehärteten Bereichen der Kleberschicht dem Walzenpaar 32, 33 zugeführt wird. Durch das Walzenpaar 32, 33 wird nun die Transferfolie 41 mit dem Verbund 63 zusammengeführt, wobei die Ausrichtung der Transferfolie 41 wie bereits oben zu den Figuren 1, 3a und 3b beschrieben, erfolgt. Die Transferfolie 41 ist wie die Transferfolie 41 nach Fig. 3a ausgeführt. Nach dem Walzenpaar 32, 33 liegt ein erster Folienverbund 64 vor, der aus der Kunststofffolie 61, der musterförmig ausgehärteten Kleberschicht und der Transferfolie 41 besteht. Der erste Folienverbund 64 wird nun einer weiteren Belichtungsstation 20, die wie in Fig. 1 aufgebaut ist, zugeführt. In den Bereichen, in denen die Kleberschicht noch nicht ausgehärtet worden war, erfolgt nun ebenfalls eine Aushärtung. Nach der Belichtungsstation 20 liegt ein zweiter Folienverbund 65 vor, der die Transferfolie 41, eine überall ausgehärtete Kleberschicht und die Kunststofffolie 61 umfasst.

Beim Abziehen der Trägerfolie 45 von dem zweiten Folienverbund 65 haftet die Dünnfilmschicht 47 in den Bereichen der Kleberschicht, die in der Belichtungsstation 20 ausgehärtet wurden, an der Kunststofffolie 61 und wird von der Trägerfolie 45 abgelöst. In den übrigen Bereichen bewirken die Adhäsionskräfte zwischen der Trägerfolie 45 und der Dünnfilmschicht 47, gegebenenfalls der Ablöseschicht 46 und der Dünnfilmschicht 47, dass in diesen Bereichen die Dünnfilmschicht 47 nicht abgelöst wird und auf der Trägerfolie 45 verbleibt. Damit ergibt sich nach Abziehen der Trägerfolie 45 ein vierter Folienverbund 66 mit einer musterförmigen Dünnfilmschicht 47, die über eine vorzugsweise vollflächig vorhandene, ausgehärtete Kleberschicht mit der Kunststofffolie 61 verbunden ist. Auf die Belichtungsstation 20 könnte gegebenenfalls verzichtet werden, wenn die Adhäsionskräfte zwischen einer nicht ausgehärteten Kleberschicht und der Dünnfilmschicht höher sind als zwischen der Dünnfilmschicht und der Trägerfolie bzw. der Ablöseschicht.

Im Weiteren erfolgt eine Weiterverarbeitung des dritten Folienverbunds 66 und des vierten Folienverbunds 67 wie bereits zu dem dritten und vierten Folienverbund 55, 56 in Fig. 1 ausgeführt.

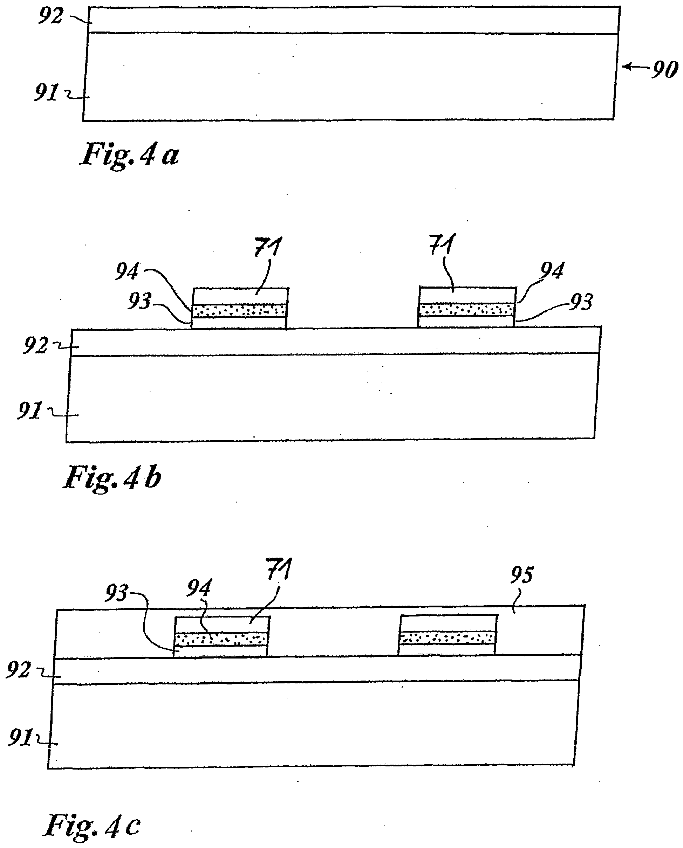

Anhand der Figuren Fig. 4a bis Fig. 4e wird nun beispielhaft erläutert, wie mittels eines der Verfahren nach Fig. 1 oder Fig. 2 ein elektronisches Bauelement in Form eines organischen Feldeffekt-Transistors (OFET) gefertigt werden kann. Dabei zeigen die Figuren 4a bis 4e Querschnittsdarstellungen der entsprechenden Schichten bzw. des Bauelements.
Fig. 4a zeigt eine Kunststofffolie 90, die aus einer Trägerfolie 91 und einer darauf aufgebrachten Lackschicht 92 besteht. Bei der Trägerfolie 91 handelt es sich um eine Folie, vorzugsweise um eine Polyester-Folie in einer Dicke im Bereich von 19 bis 38 µm. Bei der Lackschicht 92 handelt es sich um eine Lackschicht aus einem elektrisch isolierenden Material, die zusätzlich als Schutzlackschicht wirkt. Die Lackschicht 92 wird vorzugsweise in einer Schichtdicke im Bereich von 0,5 bis 5 µm auf die Trägerfolie 91 oder auf eine gegebenenfalls zwischen der Trägerfolie 91 und der Lackschicht 92 angeordnete Ablöseschicht aufgebracht.

Auf die Kunststofffolie 90 wird nun, wie in Fig. 4b gezeigt, mittels eines der Verfahren nach Fig. 1 oder Fig. 2 musterförmig eine elektrisch leitende Dünnfilmschicht 94 und auf dieser galvanisch eine Metallschicht 71 aufgebracht. Damit ergibt sich der in Fig. 4b gezeigte Folienverbund, der aus der Trägerfolie 91, der Lackschicht 92, einer Kleberschicht 93, der elektrisch leitenden Dünnfilmschicht 94 sowie der Metallschicht 71 besteht. Die Dünnfilmschicht 94 und die Metallschicht 71 bestehen hierbei jeweils aus einem Metall oder einer Metall-Legierung und bilden zusammen die Drain- und Source-Elektroden des zu bildenden OFET. Je nach Art des verwendeten Verfahrens ist es hierbei möglich, dass die Kleberschicht 93, wie in Fig. 4b gezeigt, in gleicher Weise musterförmig strukturiert ist wie die Dünnfilmschicht 94, oder dass sie vollflächig auf der Lackschicht 92 in ausgehärteter Form vorliegt.

Anschließend wird auf den Folienverbund nach Fig. 4b eine halbleitende Schicht 95 aufgebracht, so dass sich der in Fig. 4c gezeigte Folienverbund, bestehend aus der Trägerfolie 91, der Lackschicht 92, der Kleberschicht 93, der Dünnfilmschicht 94, der Metallschicht 71 und der halbleitenden Schicht 95, ergibt. Als Material für die halbleitende Schicht 95 wird hier Polythiophen verwendet, das in flüssiger, gelöster Form oder als Suspension auf den Folienverbund nach Fig. 4b aufgebracht und verfestigt wird. Auch ein musterförmig strukturierter Auftrag der halbleitenden Schicht 95 ist möglich.

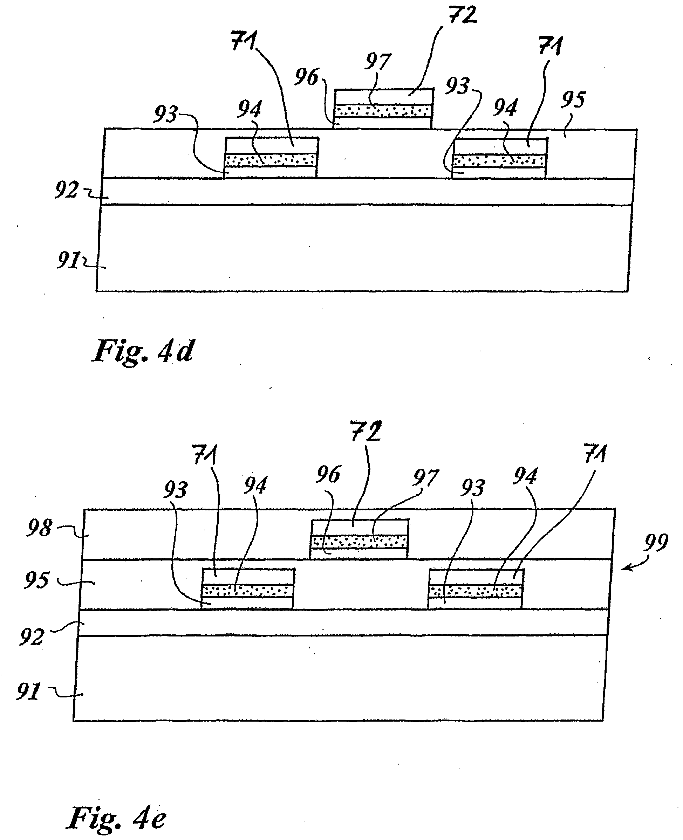

Der Folienverbund nach Fig. 4c bildet nun eine Basis, auf die mittels eines der Verfahren nach Fig. 1 oder Fig. 2 eine weitere musterförmige elektrisch leitende Dünnfilmschicht 97 aufgebracht werden kann. Fig. 4d zeigt den sich hierdurch ergebenden Folienverbund, der aus der Trägerfolie 91, der Lackschicht 92, der Kleberschicht 93, der Dünnfilmschicht 94, der Metallschicht 71, der halbleitenden Schicht 95, einer weiteren Kleberschicht 96 und der weiteren Dünnfilmschicht 97 besteht. Auf die weitere Dünnfilmschicht 97 wird galvanische eine weitere Metallschicht 72 aufgebracht, welche zusammen mit der Dünnfilmschicht 97 die Gate-Elektrode des OFET ausbildet. Die Kleberschicht 96 ist aus elektrisch isolierendem Material gebildet und musterförmig strukturiert ausgeformt. Die halbleitende Schicht 95 bildet hier eine weitere Kunststofffolie aus, auf der das Verfahren wiederholt wird. Bei Verwendung der Verfahren nach Fig. 1 oder Fig. 2 ist es aber auch möglich, dass die Kleberschicht 96 vollflächig auf der halbleitenden Schicht 95 aufgebracht ist und die Kleberschicht 96 eine weitere Kunststofffolie ausbildet, auf der das Verfahren wiederholt wird.

Sofern die galvanische Abscheidung der weiteren Metallschicht 72 die halbleitende Schicht 95 beeinträchtigt bzw. sich negativ auf die elektrischen Eigenschaften der halbleitenden Schicht 95 auswirkt, kann die Gate-Elektrode alternativ auch unmittelbar durch Sputtern oder Aufdampfen über eine Maske, durch Drucken einer elektrisch leitfähigen Paste usw. musterförmig auf der halbleitenden Schicht 95 gebildet werden.

In einem weiteren Verfahrensschritt wird nun auf den in Fig. 4d gezeigten Folienverbund eine weitere Lackschicht 98 aus einem elektrisch isolierenden Material aufgebracht, die im Weiteren auch die Funktion einer Schutzschicht für die halbleitende Schicht 95 übernimmt. Wie in Fig. 4e gezeigt, ergibt sich somit ein OFET 99, der auf der Trägerfolie 91 und der Lackschicht 92
die Kleberschicht 93, die Source- und Drain-Elektroden bestehend aus der Dünnfilmschicht 94 und der Metallschicht 71, die halbleitende Schicht 95, die Kleberschicht 96 aus einem elektrisch isolierenden Material, die Gate-Elektrode bestehend aus der weiteren Dünnfilmschicht 97 und der weiteren Metallschicht 72, sowie die Lackschicht 98 umfasst.

Eine Bildung weiterer, hier nicht dargestellter elektronischer Bauelemente oder Schaltungen ist mittels des/der erfindungsgemäßen Verfahren schnell und unkompliziert möglich.

## Patentansprüche

1. Verfahren zur Herstellung einer Leiterbahnstruktur auf einer flexiblen Kunststofffolie (51, 61, 90, 95),
bei dem
auf die Kunststofffolie (51, 61, 90, 95) oder eine Transferfolie (41) eine durch Bestrahlung vernetzbare Kleberschicht (57, 93, 96) aufgebracht wird und die Kunststofffolie (51, 61, 90, 95) und die Transferfolie (41) mittels der Kleberschicht (57, 93, 96) miteinander verbunden werden, wobei die Transferfolie (41), die eine Trägerfolie (45) und eine elektrisch leitende Dünnfilmschicht (47, 94, 97) aufweist, mit einer Orientierung der Dünnfilmschicht (47, 94, 97) zur durch Bestrahlung vernetzbaren Kleberschicht (57, 93, 96) mit der Kunststofffolie (51, 61, 90, 95) zusammengeführt wird, wobei die durch Bestrahlung vernetzbare Kleberschicht (57, 93, 96) musterförmig ausgebildet und/oder derart musterförmig bestrahlt wird, dass die Kleberschicht (57, 93, 96) nach Bestrahlung musterförmig in vernetzter, ausgehärteter Form vorliegt, und wobei die Trägerfolie (45) von dem die Kunststofffolie (51, 61, 90, 95), die zumindest bereichsweise ausgehärtete Kleberschicht (57, 93, 96) und die Dünnfilmschicht (47, 94, 97) umfassenden Folienverbund (54, 65) abgezogen wird, wobei in einem ersten musterförmigen Bereich die Dünnfilmschicht (47, 94, 97) auf der Kunststofffolie (51, 61, 90, 95) verbleibt und in einem zweiten musterförmigen Bereich die Dünnfilmschicht (47, 94, 97) auf der Trägerfolie (45) verbleibt und mit der Trägerfolie (45) von der Kunststofffolie (51, 61, 90, 95) abgezogen wird, und wobei die Leiterbahnstruktur gebildet wird, indem die im ersten musterförmigen Bereich auf der Kunststofffolie (51, 61, 90, 95) verbliebene Dünnfilmschicht (47, 94, 97) galvanisch mit mindestens einer Metallschicht (71, 72) verstärkt wird.

2. Verfahren nach Anspruch 1,
**dadurch gekennzeichnet,**
**dass** die durch Bestrahlung vernetzbare Kleberschicht (57) mittels eines Druckverfahrens musterförmig ausgebildet wird, dass die musterförmige Kleberschicht (57) durch Bestrahlung ausgehärtet wird, und dass die Trägerfolie (45) von dem die Kunststofffolie (51), die ausgehärtete musterförmige Kleberschicht (57) und die Dünnfilmschicht (47) umfassenden Folienverbund (54) abgezogen wird, wobei in dem ersten musterförmigen Bereich, in welchem die ausgehärtete Kleberschicht (57) vorliegt, die Dünnfilmschicht (47) auf der Kunststofffolie (51) verbleibt und in dem zweiten musterförmigen Bereich, in welchem keine Kleberschicht (57) vorliegt, die Dünnfilmschicht (47) auf der Trägerfolie (45) verbleibt und mit der Trägerfolie (45) von der Kunststofffolie (51) abgezogen wird.

3. Verfahren nach Anspruch 1,
**dadurch gekennzeichnet,**
**dass** die durch Bestrahlung vernetzbare Kleberschicht (57) vollflächig auf die Kunststofffolie (51, 61) oder die Transferfolie (41) aufgebracht wird und nach dem Verkleben der Transferfolie (41) mit der Kunststofffolie (51,61) musterförmig bestrahlt wird, wodurch die Kleberschicht (57) in dem ersten musterförmigen Bereich aushärtet, und dass die Trägerfolie (45) von dem die Kunststofffolie (51, 61), die bereichsweise ausgehärtet vorliegende Kleberschicht (57) und die Dünnfilmschicht (47) umfassenden Folienverbund abgezogen wird, so dass die Dünnfilmschicht (47) in dem musterförmigen ersten Bereich, in dem die ausgehärtete Kleberschicht (57) vorliegt, auf der Kunststofffolie (51, 61) verbleibt und in dem zweiten Bereich, in welchem nach wie vor die durch Bestrahlung vernetzbare Kleberschicht (57) vorliegt, mit der Trägerfolie (45) von der Kunststofffolie abgezogen wird.

4. Verfahren nach einem der Ansprüche 1 bis3,
**dadurch gekennzeichnet ,**
**dass** die Dünnfilmschicht (47, 94, 97) semi-transparent ausgebildet wird, dass die Trägerfolie (45) für die Bestrahlung durchlässig ausgebildet wird und dass die Kleberschicht (57, 93, 96) von Seiten der Transferfolie (41) durch die Transferfolie (41) hindurch bestrahlt wird.

5. Verfahren nach einem der Ansprüche 1 bis4,
**dadurch gekennzeichnet,**
**dass** die Kunststofffolie (51, 61, 90) für die Bestrahlung durchlässig ausgebildet wird und die Kleberschicht (57, 93, 96) von Seiten der Kunststofffolie (51, 61, 90, 95) durch die Kunststofffolie (51, 61, 90) hindurch bestrahlt wird.

6. Verfahren nach einem der Ansprüche 4 bis5,
**dadurch gekennzeichnet,**
**dass** die durch Bestrahlung vernetzbare Kleberschicht (57, 93, 96) eine geringere Adhäsionskraft gegenüber der Dünnfilmschicht (47, 94, 97) besitzt, als die Adhäsionskraft zwischen der Dünnfilmschicht (47, 94, 97) und der Trägerfolie (45) beträgt.

7. Verfahren nach Anspruch 1,
**dadurch gekenntzeichnet,**
dass die durch Bestrahlung vernetzbare Kleberschicht (57) vollflächig auf die Kunststofffolie (61) oder die Transferfolie (41) aufgebracht wird, dass vor dem Verkleben der Transferfolie (41) mit der Kunststofffolie (61) die Kleberschicht (57) musterförmig bestrahlt wird, so dass die Kleberschicht (57) musterförmig aushärtet, dass die Transferfolie (41) und die Kunststofffolie (61) mittels der bereichsweise ausgehärtet vorliegenden Kleberschicht (57) miteinander verklebt werden, dass die Kleberschicht (57) nun erneut bestrahlt und in weiteren oder allen Bereichen ausgehärtet wird, dass die Trägerfolie (45) von dem die Kunststofffolie (61), die zumindest bereichsweise ausgehärtete Kleberschicht (57) und die Dünnfilmschicht (47) umfassenden Folienverbund (65) abgezogen wird, so dass die Dünnfilmschicht (47) in dem ersten Bereich, in dem die Kleberschicht (57) erst nach Zusammenführen der Transferfolie (41) und der Kunststofffolie (61) ausgehärtet wurde, auf der Kunststofffolie (61) verbleibt und in dem zweiten Bereich, in dem die Kleberschicht (57) bereits vor dem Zusammenführen der Transferfolie (41) mit der Kunststofffolie (61) ausgehärtet war oder nun noch in nicht ausgehärteter Form vorliegt, mit der Trägerfolie (45) von der Kunststofffolie (61) abgezogen wird.

8. Verfahren nach einem der Ansprüche 1 bis7,
**dadurch gekennzeichnet,**
**dass** die Dünnfilmschicht (47, 94, 97) auf der Trägerfolie (45) mit einer Schichtdicke von ≤2 µm gebildet wird.

9. Verfahren nach einem der Ansprüche 1 bis8,
**dadurch gekennzeichnet,**
**dass** die Leiterbahnstruktur mit einer Schichtdicke im Bereich von 1 bis 50 µm ausgebildet wird.

10. Verfahren nach einem der Ansprüche 1 bis9,
**dadurch gekennzeichnet,**
**dass** mindestens zwei Metallschichten aus unterschiedlichen Materialien galvanisch auf der Dünnfilmschicht (47, 94, 97) ausgebildet werden.

11. Leiterbahnstruktur auf einer flexiblen Kunststofffolie (51, 61, 90, 95), herstellbar nach einem der Ansprüche 1 bis 10, wobei die Leiterbahnstruktur mittels einer durch Bestrahlung ausgehärteten Kleberschicht (57, 93, 96) mit der Kunststofffolie (51, 69, 90, 95) verbunden ist und aus einer galvanisch mit mindestens einer Metallschicht (71, 72) verstärkten, musterförmigen elektrisch leitenden Dünnfilmschicht (47, 94, 97) gebildet ist.

12. Leiterbahnstruktur nach Anspruch 11,
**dadurch gekennzeichnet,**
**dass** die Dünnfilmschicht (47, 94, 97) aus Metall oder einer Metall-Legierung, insbesondere aus Silber, Gold, Kupfer, Aluminium oder Zinn, gebildet ist oder dass die Dünnfilmschicht aus einem organischen Material, insbesondere aus PEDOT, gebildet ist.

13. Leiterbahnstruktur nach einem der Ansprüche 11 bis 12,
**dadurch gekennzeichnet ,**
**dass** die mindestens eine Metallschicht (71, 72) aus Kupfer, Chrom, Gold, Silber, Nickel oder Zink gebildet ist.

14. Elektronisches Bauelement oder elektronische Schaltung mit einer
Leiterbahnstruktur nach einem der Ansprüche 11 bis13,
**dadurch gekennzeichnet ,**
**dass** das elektronische Bauelement ein Widerstand, ein Kondensator, eine Induktivität, ein Feldeffekttransistor (FET), eine Diode, eine Leuchtdiode (LED), eine Solarzelle, ein OLED-Display oder eine Folienbatterie ist oder dass die elektronische Schaltung mindestens ein derartiges Bauelement umfasst.

15. Elektronisches Bauelement oder elektronische Schaltung nach Anspruch 14,
**dadurch gekennzeichnet,**
**dass** das Bauelement oder die Schaltung mechanisch flexibel ausgebildet ist.

## Claims

1. Method for producing a conductor track structure on a flexible plastic foil (51, 61, 90, 95),
wherein
an adhesive layer (57, 93, 96) that can be crosslinked by irradiation is applied to the plastic foil (51, 61, 90, 95) or a transfer foil (41) and the plastic foil (51, 61, 90, 95) and the transfer foil (41) are connected to each other by means of the adhesive layer (57, 93, 96), wherein the transfer foil (41) that has a carrier foil (45) and an electrically conductive thin film layer (47, 94, 97) is brought together with the plastic foil (51, 61, 90, 95) with an orientation of the thin film layer (47, 94, 97) towards the adhesive layer (57, 93, 96) that can be crosslinked by irradiation, wherein the adhesive layer (57, 93, 96) that can be crosslinked by irradiation is formed to be patterned and/or is irradiated in a patterned manner such that the adhesive layer (57, 93, 96) is present in a patterned form after irradiation in a crosslinked, cured shape, and wherein the carrier foil (45) is removed from the foil composite (54, 65) comprising the plastic foil (51, 61, 90, 95), the at least regionally cured adhesive layer (57, 93, 96) and the thin film layer (47, 94, 97), wherein the thin film layer (47, 94, 97) remains on the plastic foil (51, 61, 90, 95) in a first patterned region and the thin film layer (47, 94, 97) remains on the carrier foil (45) in a second patterned region and is removed from the plastic foil (51, 61, 90, 95) with the carrier foil (45), and wherein the conductor track structure is formed by the thin film layer (47, 94, 97) which remains on the plastic foil (51, 61, 90, 95) in the first patterned region being galvanically strengthened by means of at least one metal layer (71, 72).

2. Method according to claim 1,
**characterised in that**
the adhesive layer (57) that can be crosslinked by irradiation is formed to be patterned by means of a printing process, the patterned adhesive layer (57) is cured by irradiation, and the carrier foil (45) is removed from the foil composite (54) comprising the plastic foil (51), the cured patterned adhesive layer (57) and the thin film layer (47), wherein the thin film layer (47) remains on the plastic foil (51) in the first patterned region in which the cured adhesive layer (57) is present and the thin film layer (47) remains on the carrier foil (45) in the second patterned region in which no adhesive layer (57) is present and the thin film layer (47) is removed from the plastic foil (51) with the carrier foil (45).

3. Method according to claim 1,
**characterised in that**
the adhesive layer (57) that can be crosslinked by irradiation is applied to the plastic foil (51, 61) or the transfer foil (41) over the entire surface and is irradiated after the adhesion of the transfer foil (41) to the plastic foil (51, 61) in a patterned manner, whereby the adhesive layer (57) cures in the first patterned region, and the carrier foil (45) is removed from the foil composite comprising the plastic foil (51, 61), the adhesive layer (57) that is present and cured regionally and the thin film layer (47) such that the thin film layer (47) remains on the plastic foil (51, 61) in the patterned first region in which the cured adhesive layer (57) is present and the thin film layer (47) is removed from the plastic foil with the carrier foil (45) in the second region in which the adhesive layer (57) that can be crosslinked by irradiation is still present.

4. Method according to one of claims 1 to 3,
**characterised in that**
the thin film layer (47, 94, 97) is formed to be semi-transparent, the carrier foil (45) is formed to be transmissive for irradiation and the adhesive layer (57, 93, 96) is irradiated on the side of the transfer foil (41) through the transfer foil (41).

5. Method according to one of claims 1 to 4,
**characterised in that**
the plastic foil (51, 61, 90) is formed to be transmissive for irradiation and the adhesive layer (57, 93, 96) is irradiated on the side of the plastic foil (51, 61, 90, 95) through the plastic foil (51, 61, 90).

6. Method according to one of claims 4 to 5,
**characterised in that**
the adhesive layer (57, 93, 96) that can be crosslinked by irradiation has a lower adhesion force in relation to the thin film layer (47, 94, 97) than the adhesion force between the thin film layer (47, 94, 97) and the carrier foil (45).

7. Method according to claim 1,
**characterised in that**
the adhesive layer (57) that can be crosslinked by irradiation is applied to the plastic foil (61) or the transfer foil (41) over the entire surface, the adhesive layer (57) is irradiated in a patterned manner before the adhesion of the transfer foil (41) to the plastic foil (61)such that the adhesive layer (57) is cured in a patterned manner, the transfer foil (41) and the plastic foil (61) are adhered to each other by means of the adhesive layer (57) which is present and cured in regions, the adhesive layer (57) is now irradiated again and cured in further or all regions, the carrier foil (45) is removed from the foil composite (65) comprising the plastic foil (61), the at least regionally cured adhesive layer (57) and the thin film layer (47) such that the thin film layer (47) remains on the plastic foil (61) in the first region in which the adhesive layer (57) has been cured only after bringing the transfer foil (41) and the plastic foil (61) together and, in the second region in which the adhesive layer (57) was already cured before bringing the transfer foil (41) together with the plastic foil (61) or is now only present in a non-cured form, the thin film layer (47) is removed from the plastic foil (61) with the carrier foil (45).

8. Method according to one of claims 1 to 7,
**characterised in that**
the thin film layer (47, 94, 97) is formed on the carrier foil (45) having a layer thickness of ≤ 2 µm.

9. Method according to one of claims 1 to 8,
**characterised in that**
the conductor track structure is formed having a layer thickness ranging from 1 to 50 µm.

10. Method according to one of claims 1 to 9,
**characterised in that**
at least two metal layers made of different materials are galvanically formed on the thin film layer (47, 94, 97).

11. Conductor track structure on a flexible plastic foil (51, 61, 90, 95) that is able to be produced according to one of claims 1 to 10, wherein the conductor track structure is connected to the plastic foil (51, 61, 90, 95) by means of an adhesive layer (57, 93, 96) that is cured by irradiation and is formed from a patterned, electrically conductive thin film layer (47, 94, 97) that is galvanically strengthened by at least one metal layer (71, 72).

12. Conductor track structure according to claim 11,
**characterised in that**
the thin film layer (47, 94, 97) is formed from metal or a metal alloy, in particular from silver, gold, copper, aluminium or tin, or the thin film layer is formed from an organic material, in particular from PEDOT.

13. Conductor track structure according to one of claims 11 to 12,
**characterised in that**
the at least one metal layer (71, 72) is formed from copper, chromium, gold, silver, nickel or zinc.

14. Electronic component or electronic switch having a conductor track structure according to one of claims 11 to 13,
**characterised in that**
the electronic component is a resistor, a capacitor, an inductor, a field effect transistor (FET), a diode, a light-emitting diode (LED), a solar cell, an OLED display or a foil battery or the electronic switch comprises at least one such component.

15. Electronic component or electronic switch according to claim 14,
**characterised in that**
the component or the switch is formed to be mechanically flexible.

## Revendications

1. Procédé pour la fabrication d'une structure de piste conductrice sur une feuille plastique (51, 61, 90, 95) flexible,
où
est appliquée, sur la feuille plastique (51, 61, 90, 95) ou une feuille de transfert (41), une couche d'adhésif (57, 93, 96) réticulable par irradiation, et la feuille plastique (51, 61, 90, 95) et la feuille de transfert (41) sont reliées ensemble au moyen de la couche d'adhésif (57, 93, 96), dans lequel la feuille de transfert (41), laquelle présente une feuille de support (45) et une couche de feuille mince (47, 94, 97) électroconductrice, est réunie, avec une orientation de la couche de feuille mince (47, 94, 97) par rapport à la couche d'adhésif (57, 93, 96) réticulable par irradiation, avec la feuille plastique (51, 61, 90, 95), dans lequel la couche d'adhésif (57, 93, 96) réticulable par irradiation est réalisée en forme de motif et/ou est irradiée en forme de motif de telle manière qu'après l'irradiation, la couche d'adhésif (57, 93, 96) se présente en forme de motif sous une forme réticulée et durcie, et dans lequel la feuille de support (45) est enlevée du jointage de feuilles (54, 65) comprenant la feuille plastique (51, 61, 90, 95), la couche d'adhésif (57, 93, 96) durcie au moins par endroits et la couche de feuille mince (47, 94, 97), dans lequel, dans une première zone en forme de motif, la couche de feuille mince (47, 94, 97) subsiste sur la feuille plastique (51, 61, 90, 95) et dans une deuxième zone en forme de motif, la couche de feuille mince (47, 94, 97) subsiste sur la feuille de support (45) et est enlevée avec la feuille de support (45) de la feuille plastique (51, 61, 90, 95), et dans lequel la structure de piste conductrice est formée en ce que la couche de feuille mince (47, 94, 97) subsistant sur la feuille plastique (51, 61, 90, 95) dans la première zone en forme de motif est renforcée galvaniquement avec au moins une couche métallique (71, 72).

2. Procédé selon la revendication 1,
**caractérisé en ce**
**que** la couche d'adhésif (57) réticulable par irradiation est réalisée en forme de motif au moyen d'un procédé d'impression, que la couche d'adhésif (57) en forme de motif est durcie par irradiation, et que la feuille de support (45) est enlevée du jointage de feuilles (54) comprenant la feuille plastique (51), la couche d'adhésif (57) en forme de motif durcie et la couche de feuille mince (47), dans lequel, dans la première zone en forme de motif, dans laquelle se trouve la couche d'adhésif (57) durcie, la couche de feuille mince (47) subsiste sur la feuille plastique (51) et dans la deuxième zone en forme de motif, dans laquelle il n'y a pas de couche d'adhésif (57), la couche de feuille mince (47) subsiste sur la feuille de support (45) et est enlevée avec la feuille de support (45) de la feuille plastique (51).

3. Procédé selon la revendication 1,
**caractérisé en ce**
**que** la couche d'adhésif (57) réticulable par irradiation est appliquée sur toute la surface sur la feuille plastique (51, 61) ou la feuille de transfert (41) et est irradiée en forme de motif après le collage de la feuille de transfert (41) avec la feuille plastique (51, 61), moyennant quoi la couche d'adhésif (57) durcie dans la première zone en forme de motif, et que la feuille de support (45) est enlevée du jointage de feuilles comprenant la feuille plastique (51, 61), la couche d'adhésif (57) se présentant de manière durcie par endroits et la couche de feuille mince (47) de sorte que la couche de feuille mince (47) subsiste sur la feuille plastique (51, 61) dans la première zone en forme de motif, dans laquelle se trouve la couche d'adhésif (57) durcie, et est enlevée avec la feuille de support (45) de la feuille plastique dans la deuxième zone, dans laquelle se trouve toujours la couche d'adhésif (57) réticulable par irradiation.

4. Procédé selon l'une des revendications 1 à 3,
**caractérisé en ce**
**que** la couche de feuille mince (47, 94, 97) est réalisée de manière semi-transparente, que la feuille de support (45) est réalisée de manière transparente pour l'irradiation et que la couche d'adhésif (57, 93, 96) est irradiée depuis le côté de la feuille de transfert (41) à travers la feuille de transfert (41).

5. Procédé selon l'une des revendications 1 à 4,
**caractérisé en ce**
**que** la feuille plastique (51, 61, 90) est réalisée de manière transparente pour l'irradiation et que la couche d'adhésif (57, 93, 96) est irradiée depuis le côté de la feuille plastique (51, 61, 90, 95) à travers la feuille plastique (51, 61, 90).

6. Procédé selon l'une des revendications 4 à 5,
**caractérisé en ce**
**que** la couche d'adhésif (57, 93, 96) réticulable par irradiation possède une force d'adhésion par rapport à la couche de feuille mince (47, 94, 97) inférieure à la force d'adhésion entre la couche de feuille mince (47, 94, 97) et la feuille de support (45).

7. Procédé selon la revendication 1,
**caractérisé en ce**
**que** la couche d'adhésif (57) réticulable par irradiation est appliquée sur toute la surface sur la feuille plastique (61) ou la feuille de transfert (41), que la feuille d'adhésif (57) est irradiée en forme de motif avant le collage de la feuille de transfert (41) avec la feuille plastique (61) de sorte que la couche d'adhésif (57) durcisse en forme de motif, que la feuille de transfert (41) et la feuille plastique (61) sont collées ensemble au moyen de la couche d'adhésif (57) se présentant de manière durcie par endroits, que la couche d'adhésif (57) est alors de nouveau irradiée et est durcie dans d'autres ou toutes les zones, que la feuille de support (45) est enlevée du jointage de feuilles (65) comprenant la feuille plastique (61), la couche d'adhésif (57) durcie au moins par endroits et la couche de feuille mince (47) de sorte que la couche de feuille mince (47) subsiste sur la feuille plastique (61) dans la première zone, dans laquelle la couche d'adhésif (57) a durci seulement après la réunion de la feuille de transfert (41) et de la feuille plastique (61), et soit enlevée avec la feuille de support (45) de la feuille plastique (61) dans la deuxième zone, dans laquelle la couche d'adhésif (57) avait déjà durci avant la réunion entre la feuille de transfert (41) et la feuille plastique (61) ou se trouve alors encore sous une forme non durcie.

8. Procédé selon l'une des revendications 1 à 7,
**caractérisé en ce**
**que** la couche de feuille mince (47, 94, 97) sur la feuille de support (45) est formée avec une épaisseur de couche ≤ 2 µm.

9. Procédé selon l'une des revendications 1 à 8,
**caractérisé en ce**
**que** la structure de piste conductrice est réalisée avec une épaisseur de couche dans la plage de 1 à 50 µm.

10. Procédé selon l'une des revendications 1 à 9,
**caractérisé en ce**
**qu'**au moins deux couches métalliques en matériaux différents sont réalisées galvaniquement sur la couche de feuille mince (47, 94, 97).

11. Structure de piste conductrice sur une feuille plastique (51, 61, 90, 95) flexible pouvant être fabriquée selon l'une des revendications 1 à 10, dans laquelle la structure de piste conductrice est reliée à la feuille plastique (51, 61, 90, 95) au moyen d'une couche d'adhésif (57, 93, 96) durcie par irradiation et est formée par une couche de feuille mince (47, 94, 97) électroconductrice en forme de motif renforcée galvaniquement avec au moins une couche métallique (71, 72).

12. Structure de piste conductrice selon la revendication 11,
**caractérisée en ce**
**que** la couche de feuille mince (47, 94, 97) est formée en métal ou un alliage métallique, en particulier en argent, or, cuivre, aluminium ou étain, ou que la couche de feuille mince est formée en un matériau organique, en particulier en PEDOT.

13. Structure de piste conductrice selon l'une des revendications 11 à 12,
**caractérisée en ce**
**que** l'au moins une couche métallique (71, 72) est formée en cuivre, chrome, or, argent, nickel ou zinc.

14. Composant électronique ou circuit électronique avec une structure de piste conductrice selon l'une des revendications 11 à 13,
**caractérisé en ce**
**que** le composant électronique comprend une résistance, un condensateur, une inductance, un transistor à effet de champ (FET), une diode, une diode électroluminescente (DEL), une cellule solaire, un afficheur OLED ou une pile en feuille, ou que le circuit électronique comprend au moins un tel composant.

15. Composant électronique ou circuit électronique selon la revendication 14,
**caractérisé en ce**
**que** le composant ou le circuit est réalisé à flexibilité mécanique.
